(19) Europäisches Patentamt European Patent Office Office européen des brevets

(11) **EP 4 574 436 A1**

(12) **EUROPÄISCHE PATENTANMELDUNG**

(43) Veröffentlichungstag:
   **25.06.2025   Patentblatt 2025/26**

(21) Anmeldenummer: **23218949.8**

(22) Anmeldetag: **21.12.2023**

(51) Internationale Patentklassifikation (IPC):
   **B41J 3/407** *(2006.01)*      **B41M 5/00** *(2006.01)*

(52) Gemeinsame Patentklassifikation (CPC):
   **B41J 3/4073;** B41M 5/0088; H05K 3/00

(84) Benannte Vertragsstaaten:
   **AL AT BE BG CH CY CZ DE DK EE ES FI FR GB GR HR HU IE IS IT LI LT LU LV MC ME MK MT NL NO PL PT RO RS SE SI SK SM TR**
   Benannte Erstreckungsstaaten:
   **BA**
   Benannte Validierungsstaaten:
   **KH MA MD TN**

(71) Anmelder: **Heraeus Electronics GmbH & Co. KG**
   **63450 Hanau (DE)**

(72) Erfinder:
   • **Opiolka-Schäfer, Thorsten**
     **63450 Hanau (DE)**
   • **Stadnik, Allan Paul**
     **63450 Hanau (DE)**
   • **Sternkiker, Christoph**
     **63450 Hanau (DE)**
   • **Neudecker, Urs**
     **63450 Hanau (DE)**

(74) Vertreter: **Heraeus IP**
   **Heraeus Business Solutions GmbH**
   **Intellectual Property**
   **Heraeusstraße 12-14**
   **63450 Hanau (DE)**

(54) **TINTENDRUCKVERFAHREN ZUM KONTINUIERLICHEN BEDRUCKEN EINER OBERSEITE UND EINER SEITENFLÄCHE EINES DREIDIMENSIONALEN OBJEKTS, EIN ZUGEHÖRIGES COMPUTERPROGRAMM SOWIE COMPUTER-LESBARES SPEICHERMEDIUM**

(57)   Die vorliegende Erfindung betrifft ein Tintenstrahldruckverfahren zum kontinuierlichen Bedrucken zumindest eines Abschnittes einer Oberseite 110 und zumindest eines Abschnittes einer Seitenfläche 120 eines dreidimensionalen (3D) Objekts 100 mit Tinte. Erfindungsgemäß werden vor dem Bedrucken des Objekts 100 die Druckdaten für die Druckdüsen A1 einer ersten Druckdüsenreihe A mit einem ersten Korrekturfaktor KA und/oder die Druckdaten für die Druckdüsen B1 einer zweiten Druckdüsenreihe B mit einem zweiten Korrekturfaktor KB korrigiert, wobei der erste Korrekturfaktor KA und/oder der zweite Korrekturfaktor KB anhand eines zuvor erzeugten Vergleichsdruckbildes, das zuvor ohne Korrektur erzeugt wurde, bestimmt wird/werden, und wobei der erste Korrekturfaktor KA und/oder der zweite Korrekturfaktor KB abhängig ist vom Abstand d der Druckzeile DA, die von den Druckdüsen A1 der ersten Druckdüsenreihe A erzeugt wurde, zu der Druckzeile DB, die von den Druckdüsen B1 der zweiten Druckdüsenreihe B erzeugt wurde, in dem zuvor erzeugten Vergleichsdruckbild.

Fig. 6

EP 4 574 436 A1

**Beschreibung**

GEBIET DER ERFINDUNG

Die vorliegende Erfindung betrifft ein Tintendruckverfahren zum kontinuierlichen Bedrucken zumindest eines Abschnittes einer Oberseite und zumindest eines Abschnittes einer Seitenfläche eines dreidimensionalen (3D) Objekts mit Tinte. Die vorliegende Erfindung bezieht sich auch auf ein zugehöriges Computerprogramm sowie ein computerlesbares Medium, auf dem das Computerprogramm gespeichert ist.

HINTERGRUND DER ERFINDUNG

Es gibt eine Vielzahl unterschiedlicher Druckverfahren, wie zum Beispiel die Offsetlithografie, die Flexografie, der Siebdruck, der Tiefdruck und der Digitaldruck. Beim Digitaldruck, beispielsweise beim Tintenstrahldruck und der Xerografie, wird ein digitales Bild direkt auf verschiedenartige Medien gedruckt.

Tintenstrahldruckverfahren werden häufig für das Bedrucken von Papier verwendet, wobei der Schwerpunkt auf zweidimensionalen Oberflächen liegt. Tintenstrahldruckverfahren können jedoch auch für andere Zwecke eingesetzt werden. Sie können zum Beispiel zum Aufbringen einer funktionalen Schicht oder eines funktionalen Druckmusters auf dreidimensionale Objekte verwendet werden, wie zum Beispiel zum Auftragen von leitfähiger Tinte auf ein "System in Package" (SIP), um dieses vor elektromagnetischen Störungen zu schützen.

SIP-Module spielen eine immer wichtigere Rolle bei der Miniaturisierung von tragbaren elektronischen Geräten. Aufgrund der hohen Dichte der in einem SIP-Modul eingebauten elektrischen Funktionen können elektromagnetische oder elektrische Störungen (EMI) zu einem vollständigen Ausfall des Moduls führen. Aus diesem Grund müssen SIP-Module abgeschirmt werden, um zu verhindern, dass EMI-Strahlung vom SIP-Modul ausgeht und von ihm empfangen wird.

Traditionell verwenden SIP-Module ein Metallgehäuse zur EMI-Abschirmung. Ein Metallgehäuse konterkariert jedoch das Ziel der Miniaturisierung. Anstelle eines Metallgehäuses kann eine funktionale Schicht aufgebracht werden, zum Beispiel durch eine physikalische Gasphasenabscheidung (PVD-Verfahren). Alternativ kann z.B. auch eine silberhaltige Tinte mit einem Tintenstrahldrucker auf die Oberfläche eines SIP-Moduls aufgedruckt werden. Nachdem die Tinte auf die Oberfläche des SIP-Moduls gedruckt wurde, wird die Tinte z.B. mit UV-Licht ausgehärtet, um eine durchgehende Funktionsschicht auf der Oberfläche des SIP-Moduls zu bilden. Auch andere Aushärtungsmethoden sind denkbar, wie zum Beispiel durch IR-Strahlung oder Plasma. Vor dem Druckprozess kann die Oberfläche des SIP-Moduls einer Vorbehandlung zu Reinigungszwecken unterzogen werden. Auch hier kann Plasma zum Einsatz kommen.

Additive Tintenstrahldruckverfahren zum Drucken eines funktionalen Druckmusters (oder auch einer anderweitigen Schicht) auf ein dreidimensionales Objekt, wie z. B. ein elektronisches Gerät, unterscheiden sich deutlich von Tintenstrahldruckverfahren, die für grafische Zwecke verwendet werden. Während bei grafischen Druckverfahren die Flächendichte (g/cm2) und ggf. der Farbton der auf ein bestimmtes Substrat, wie z.B. Papier, aufgebrachten Tinte der wichtigste Faktor ist, ist beim Druck eines funktionalen Druckmusters auf ein elektronisches Gerät, wie z. B. ein SIP-Modul, unter anderem die Schichtdicke von großer Bedeutung. Die endgültige Schichtdicke, die Materialdichte (g/cm3) und die strukturelle Gleichmäßigkeit und Homogenität in den Dickenrichtungen sowie über die Oberfläche des funktionalen Druckmusters haben entscheidenden Einfluss auf dessen Funktion, wobei auch Effizienz und wirtschaftliche Aspekte zu berücksichtigen sind.

Jedoch wurde festgestellt, dass beim Tintenstrahldruckverfahren, um eben eine Schicht auf ein dreidimensionales Objekt aufzudrucken, die Schichtränder in der Regel auf den Seitenflächen des dreidimensionalen Objekts, wie z. B. eines quaderförmigen elektronischen Bauteils, unscharf sind, d.h. keine klar definierte Kante aufweisen. Diese Unschärfe wird gewöhnlich auch als Waviness bezeichnet. Diese Waviness zeigt sich meist in einer wellenförmigen Druckkante, was wiederum dazu führt, dass die Tintenschicht nicht in unmittelbarer Nähe leitfähiger Komponenten gedruckt werden kann. Um elektrische Kurzschlüsse zu verhindern, muss ein Sicherheitsabstand eingehalten werden. Darüber hinaus kommt es auch beim Bedrucken von Flächen, die nicht planparallel zum Druckkopf eines Tintenstrahldruckers sind, zu ungenauen und welligen Druckkanten.

In US 2019/0270306 A1 wird ein Tintenstrahldruckverfahren beschrieben, bei dem von dem zu bedruckenden Objekt ein Höhenprofil erstellt und hierdurch der Abstand des zu bedruckenden Objekts zu jeder Druckdüse des Druckkopfes bestimmt wird. Sodann werden die Abschusszeiten aus den einzelnen Druckdüsen so gesteuert, dass sie abhängig von der Relativgeschwindigkeit zwischen dem zu bedruckenden Objekt und jeder Düse sind.

In US 11,234,334 B2 werden etwaige Druckungenauigkeiten dadurch korrigiert, indem eine sogenannte ideale Bewegungsbahn ermittelt wird, wodurch transducergesteuert eine genaue Tropfenauftreffposition auf dem zu bedruckenden Objekt erreicht werden kann.

Wie es zu den zuvor genannten welligen Druckkanten kommt, oder woraus sie resultieren, wird nun im Anschluss erläutert.

Gewöhnlich wird der Druckkopf eines Tintenstrahldruckers relativ zu einem zu bedruckenden Objekt (Druckobjekt) so montiert, dass seine Druckdüsenebene, d.h. diejenige Ebene, in der für gewöhnlich sämtliche Druckdüsen des Druckkopfes liegen, parallel zum Druckobjekt ist. Der Druckkopf wird sodann geradlinig über das Druckobjekt bewegt, so dass jede Druckdüse den gleichen Abstand zur Oberseite des Druckobjekts aufweist.

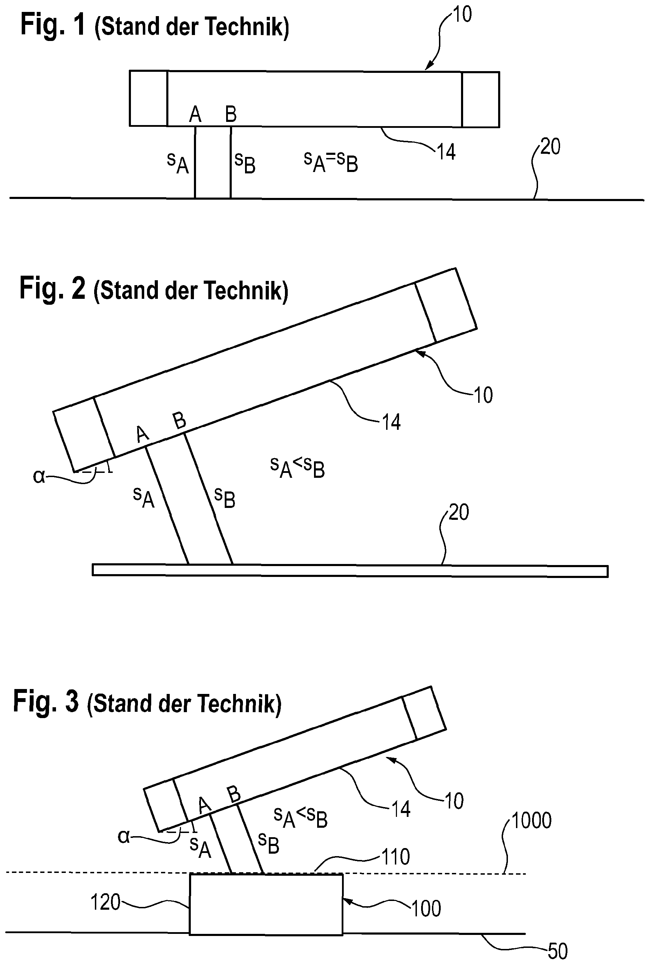

Diese Situation ist in Fig. 1 dargestellt, in der der Druckkopf 10 mit seiner lediglich schematisch angedeuteten Druckdüsenebene 14 parallel zu einem flächigen, zweidimensionalen Druckobjekt 20 angeordnet ist. Die Bezugszeichen A und B deuten auf Druckdüsenreihen des Druckkopfes 10 hin. Jede Druckdüsenreihe A, B umfasst eine Vielzahl von Druckdüsen, die linear entlang jeder Druckdüsenreihe A, B angeordnet sind und in Fig. 1 sich in die Blattebene erstrecken. Der Abstand der Druckdüsenreihe A zum zweidimensionalen Druckobjekt 20 entspricht $S_A$, und der Abstand der Druckdüsenreihe B zum zweidimensionalen Druckobjekt 20 entspricht $S_B$. Während der gesamten Bewegung des Druckkopfes 10 über das zweidimensionale Druckobjekt 20 hinweg, d.h. während des gesamten Druckvorgangs, ist der Abstand $S_A$ gleich dem Abstand $S_B$. Unterschiedliche Auftreffpunkte der Tintentropfen auf dem zweidimensionalen Druckobjekt 20 hängen ausschließlich von dem mechanisch vorgegebenen Abstand der Druckdüsenreihe A zur Druckdüsenreihe B in der Druckdüsenebene 14 des Druckkopfes 10 ab. Der Abstand der Druckdüsenreihen A, B untereinander ist ein konstanter Wert, so dass eine scharfe Druckkante, z.B. am äußersten linken Rand in Fig. 1, auf dem zweidimensionalen Druckobjekt 20 dadurch erzielt werden kann, dass die Abschusszeiten der Tintentropfen aus der Druckdüsenreihe A und der Druckdüsenreihe B zu unterschiedlichen Zeitpunkten erfolgen.

Unter Bezugnahme auf die Fig. 2 ist zu sehen, wie sich der Abstand der einzelnen Druckdüsenreihen A und B zu dem zweidimensionalen Druckobjekt 20 ändert, wenn der Druckkopf 10 relativ zu dem zweidimensionalen Druckobjekt 20 geneigt ist. In dem in Fig. 2 dargestellten Beispiel ist der Abstand $S_A$ der Druckdüsenreihe A zum Druckobjekt 20 kleiner als der Abstand $S_B$ der Druckdüsenreihe B zum Druckobjekt 20. Bleibt der Druckkopf 10 über seine gesamte Bewegungslänge hinweg parallel zum Druckobjekt 20, woraus folgt, dass die Abstände $S_A$ und $S_B$ ebenfalls über den gesamten Verfahrweg des Druckkopfes 10 konstant bleiben, kann durch Anpassung der Abschusszeiten der Tintentropfen der Höhenunterschied der beiden Druckdüsenreihen A und B zum Druckobjekt 20 ausgeglichen und ein klar definierter Druckrand erzielt werden. Alternativ könnte auch hier ein Höhenprofil des Druckobjekts 20 vor dem eigentlichen Druckvorgang gemäß US 2019/0270306 A1 oder eine ideale Bewegungsbahn gemäß US 11,234,334 B2 bestimmt werden.

In Fig. 3 ist eine Situation dargestellt, bei der der Druckkopf 10 zum Druckobjekt 100 geneigt angeordnet ist, das Druckobjekt 100 allerdings ein dreidimensionales Druckobjekt 100 ist im Unterschied zum zweidimensionalen Druckobjekt 20 der Fig. 2. Der Druckkopf 10 wird auf die Oberseite 110 des Druckobjekts 100 ausgerichtet, indem etwaige Höhenunterschiede der Druckdüsenreihen A und B über variierende Abschusszeiten der Tintentropfen kompensiert werden. Als Justier- oder Referenzebene 1000 dient hierfür die Oberseite 110 des Druckobjekts 100, das auf einer planaren Ebene 50 positioniert ist. Unter Verwendung dieser Referenzebene 1000 verhält sich der geneigte Druckkopf 10 wie ein paralleler Druckkopf 10 in der Fig. 1 unter der Voraussetzung, dass sich der geneigte Druckkopf 10 der Fig. 3 entlang einer Bewegungsbahn bewegt, die parallel zur Referenzebene 1000 ist.

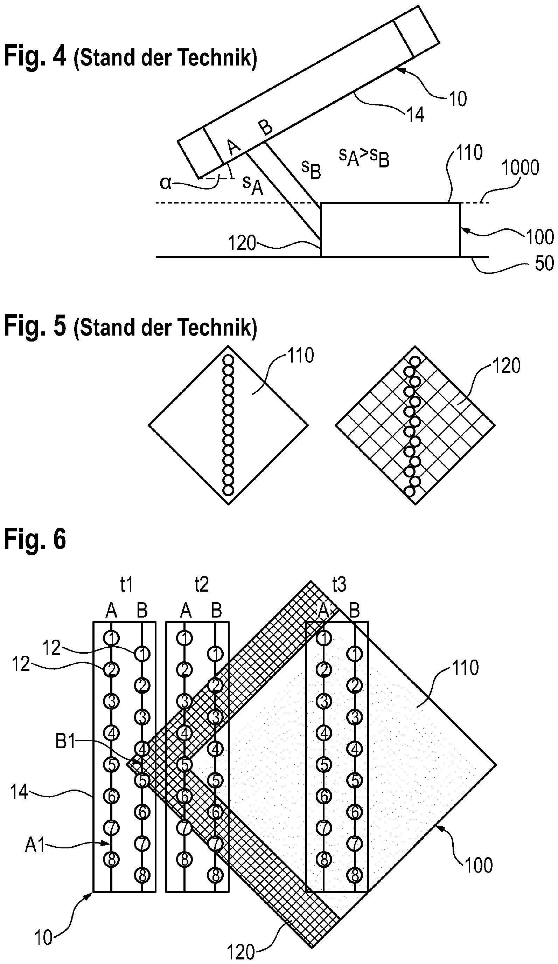

Beim Bedrucken der Seitenwand 120 des Druckobjekts 100 kehren sich jedoch die Abstände $S_A$ und $S_B$ der Druckdüsenreihen A und B zur Seitenwand 120 um, wie in Fig. 4 zu erkennen ist. In diesem Fall steht die Seitenwand 120 unter einem 90°-Winkel zur Oberseite 110 des Druckobjekts 100, wodurch der Druckkopf 10 die Seitenwand 120 um 90° gedreht "sieht". Dies erklärt, warum der Abstand $S_A$' der Druckdüsenreihe A zur Seitenfläche 120 größer ist als der Abstand $S_B$' der Druckdüsenreihe B zur Seitenfläche 120, während der Abstand $S_A$ der Druckdüsenreihe A zur Oberseite 110 kleiner ist als der Abstand $S_B$ der Druckdüsenreihe B zur Oberseite 110.

Wird nun die Seitenwand 120 und die Oberseite 110 in einem kontinuierlichen ("online") Druckvorgang bedruckt, ergibt sich auf der Seitenwand 120 keine klar definierte Druckkante mehr, wenn der Druckkopf 10, genauer gesagt die Abschusszeiten der Düsen der beiden Druckdüsenreihen A und B, auf die Referenzebene 1000, welche in diesem Fall die Oberseite 110 des Druckobjekts 100 umfasst, justiert ist. Im Gegensatz zur Seitenwand 120 erhält man auf der Oberseite 120, wie in Fig. 5 deutlich zu sehen ist, eine geradlinige, scharfe und klar definierte Druckkante ohne signifikante geometrische Abweichungen in lateraler Richtung (Waviness). Mit anderen Worten, eine Druckzeile DA, die von der Druckdüsenreihe A auf der Oberseite 110 des Druckobjekts 100 gedruckt wird, liegt auf der gleichen Linie wie die Druckzeile DB, die von der Druckdüsenreihe B auf der Oberseite 110 des Druckobjekts 100 erzeugt wird, während die Druckzeilen DA und DB auf der Seitenwand 120 einen Versatz (Waviness), und somit einen Abstand zueinander aufweisen.

Um auch auf der Seitenwand 120 eine klar definierte gerade Druckkante zu erhalten, wäre gemäß dem Stand der Technik ein mehrstufiger Prozess notwendig. So könnte beispielsweise sowohl ein Höhenprofil der Seitenwand 120 als auch ein Höhenprofil der Oberseite 110 gemäß US 2019/0270306 A1 erzeugt werden oder alternativ eine ideale Bewegungsbahn gemäß US 11,234,334 B2 ermittelt werden. Alternativ könnte der Druckkopf 10 in einem ersten Schritt auf die Seitenwand 120 als Referenzebene ausgerichtet werden, und in einem zweiten Schritt könnte der Druckkopf 10 auf die Oberseite 110 als Referenzebene 1000 ausgerichtet werden. Dabei könnte der Druckkopf 10 sowohl parallel als auch geneigt zur jeweiligen Referenzebene 1000 angeordnet werden. Ein Bedrucken der Seitenwand 120 und der Oberseite 110 könnte dann allerdings nur in einem mehrstufigen, nicht kontinuierlichen Druckvorgang erfolgen.

Es ist daher eine Aufgabe der vorliegenden Erfindung, ein Tintenstrahldruckverfahren bereitzustellen, das die im Stand der Technik existierenden Nachteile abschwächt oder gar überwindet. Insbesondere ist es ein Ziel der vorliegenden Erfindung, ein Tintenstrahldruckverfahren bereitzustellen, mit dessen Hilfe in einem kontinuierlichen Druckvorgang die Schärfe der Druckkanten sowohl auf der Oberseite als auch auf der Seitenfläche eines dreidimensionalen Druckobjekts verbessert wird.

Diese Aufgaben werden durch den Gegenstand der unabhängigen Patentansprüche gelöst. Optionale bzw. bevorzugte Merkmale der vorliegenden Erfindung sind Gegenstand der abhängigen Ansprüche.

## ZUSAMMENFASSUNG DER ERFINDUNG

Gemäß einem ersten Aspekt der vorliegenden Erfindung wird ein Tintenstrahldruckverfahren zum kontinuierlichen Bedrucken zumindest eines Abschnitts einer Oberseite und zumindest eines Abschnitts einer Seitenfläche eines dreidimensionalen (3D) Objekts mit Tinte bereitgestellt. Dieses Verfahren umfasst das Bereitstellen eines dreidimensionalen Objekts auf einer planaren Ebene, das Bereitstellen eines Druckkopfes mit einer Vielzahl von Druckdüsen zum Ausgeben von Tinte in Form von Tropfen, wobei die Vielzahl von Druckdüsen sich in einer zweidimensionalen Druckdüsenebene erstreckt, und wobei ein erster Teil der Vielzahl von Druckdüsen in einer ersten Druckdüsenreihe und ein zweiter Teil der Vielzahl von Druckdüsen in einer zweiten Druckdüsenreihe angeordnet sind, und wobei die erste Druckdüsenreihe von der zweiten Druckdüsenreihe in der Druckdüsenebene beabstandet ist, und wobei die Druckdüsenebene unter einem Winkel $\alpha$ zur planaren Ebene angeordnet ist. Das Verfahren umfasst des Weiteren das Erzeugen von Druckdaten für jede Druckdüse der Vielzahl von Druckdüsen sowohl für den zu bedruckenden Abschnitt der Oberseite als auch für den zu bedruckenden Abschnitt der Seitenfläche des Objekts, und das Verursachen einer Relativbewegung zwischen dem Objekt und dem Druckkopf und das zeilenförmige Bedrucken des Abschnitts der Oberseite und des Abschnitts der Seitenfläche des Objekts mit Tinte. Das erfindungsgemäße Verfahren ist dadurch gekennzeichnet, dass vor dem Bedrucken des Abschnitts der Oberseite und des Abschnitts der Seitenfläche des Objekts die Druckdaten für die Druckdüsen der ersten Druckdüsenreihe mit einem ersten Korrekturfaktor und/oder die Druckdaten für die Druckdüsen der zweiten Druckdüsenreihe mit einem zweiten Korrekturfaktor korrigiert werden, und dass der erste Korrekturfaktor und/oder der zweite Korrekturfaktor anhand eines zuvor erzeugten Vergleichsdruckbildes, das zuvor ohne Korrektur erzeugt wurde, bestimmt wird, und dass der erste Korrekturfaktor und/oder der zweite Korrekturfaktor abhängig ist vom Abstand der Druckzeile, die von den Druckdüsen der ersten Druckdüsenreihe erzeugt wurde, zu der Druckzeile, die von den Druckdüsen der zweiten Druckdüsenreihe erzeugt wurde, in dem zuvor erzeugten Vergleichsdruckbild.

Die vorliegende Erfindung eignet sich allgemein zum Aufbringen jeder Art von Beschichtung auf ein zu bedruckendes dreidimensionales Objekt (im folgenden Druckobjekt genannt). Als Materialien für die Beschichtung kommen vorzugsweise elektrisch leitfähige Materialien in Betracht. Als Beispiel für ein solches elektrisch leitfähige Material sei vorzugsweise eine leitfähige Tinte genannt, d.h. eine Art Tinte, die beim Drucken und vorzugsweise beim Aushärten elektrisch leitfähige Eigenschaften erzeugt. Beispiele für solche Tintenarten sind eine Silber-, Gold-, Titan-, Wismut-, Nickel-, Chrom- oder Kupfertinte oder eine silber-, gold-, titan-, wismut-, nickel-, chrom- oder kupferhaltige Tinte, vorzugsweise eine Tinte, die metallorganische Zersetzungsverbindungen (MOD) enthält, auch bekannt als MOD-Tinte. Die leitfähige Tinte kann auch leitfähige Partikel enthalten, z. B. Silber-, Gold-, Titan-, Bismut-, Nickel-, Chrom- oder Kupferpartikel.

Eine derart elektrisch leitfähige Schicht kann dazu dienen, das Druckobjekt vor vorzugsweise elektromagnetischen Interferenzen (EMI) abzuschirmen. Vorteilhaft ist eine solche Abschirmung insbesondere dann, wenn es sich bei dem 3D Druckobjekt um ein elektronisches Bauteil, beispielsweise um eine 3D-Elektronikbaugruppe handelt, um elektromagnetische Interferenzen (EMI), die durch elektromagnetische Induktion oder elektromagnetische Strahlung verursacht werden, die von einem elektronischen Gerät innerhalb der 3D-Elektronikbaugruppe oder von einer externen Quelle ausgeht, abzuschirmen. Die elektrisch leitfähige Schicht kann jedoch vorzugsweise auch als Leiterbahn einer elektronischen Schaltung ausgeführt sein, oder so geformt sein, dass sie eine Funktion z.B. einer Antenne in einer Antenna-in-Package (AIP) übernimmt.

Die Dicke der elektrisch leitfähigen Schicht liegt vorzugsweise in einem Bereich von 0,0001 $\mu m$ bis 100 $\mu m$, noch bevorzugter in einem Bereich von 0,001 $\mu m$ bis 50 $\mu m$, noch bevorzugter in einem Bereich von 0,1 $\mu m$ bis 5 $\mu m$ und noch bevorzugter in einem Bereich von 1 $\mu m$ bis 4 $\mu m$.

Wird beispielsweise eine leitfähige Tinte als Material für die elektrisch leitfähige Schicht verwendet, und damit die elektrisch leitfähige Schicht beispielsweise als EMI-Abschirmung wirken kann, muss der Druck so erfolgen, dass die leitfähige Tinte zumindest auf Teilen der freiliegenden Oberflächen des elektronischen Bauteils eine durchgehende Schicht bildet, die keine Lücken aufweist, die größer sind als eine Viertelwellenlänge der Frequenz der zu blockierenden externen oder internen elektromagnetischen Strahlung.

Nach jedem oder einer bestimmten Anzahl von Druckschritten kann die elektrisch leitfähige Schicht ausgehärtet werden. Wird eine Tinte verwendet, die vernetzt werden muss, kann die vernetzte Tinte einem weiteren chemischen Reduktionsschritt unterzogen werden, bei dem sich Metall in Form von Nanopartikeln abscheidet.

Etwaige Lösungsmittel verdampfen, und die gedruckte Tinte wird gesintert. Unter Aushärtung versteht man alle diese chemischen Prozesse, die bei bestimmten Druckfarben auftreten.

Sobald die gedruckte elektrisch leitfähige Schicht ausgehärtet ist, erhält man eine Funktionsschicht, die vorzugsweise eine EMI-Abschirmfunktion aufweist. Die Aushärtung kann zum Beispiel mit UV-Licht erfolgen. Auch andere Aushärtungsverfahren sind denkbar, wie z. B. Ofenhärtung, IR-Strahlung oder Plasma. Vor dem Druckprozess kann die Oberfläche der 3D-Elektronikbaugruppe einer Vorbehandlung zu Reinigungszwecken unterzogen werden, z. B. durch den Einsatz von Plasma.

Die elektrisch leitfähige Schicht kann auch eine nichtleitende Schicht, z. B. eine Schutzschicht, enthalten, die die leitfähige Schicht unter der Schutzschicht vor Beschädigung und/oder anderen ungünstigen Umwelteinflüssen, wie übermäßiger Hitze und korrosionsfördernden Substanzen, z.B. Sauerstoff, schützt.

Mit dem erfindungsgemäßen Verfahren kann die elektrisch leitfähige Schicht nur auf bestimmten Abschnitten oder auf der gesamten freiliegenden Oberfläche(n) des elektronischen Bauteils aufgedruckt werden, und die Schichtdicke kann selektiv so eingestellt werden, dass sie über die gedruckten Abschnitte der freiliegenden Oberfläche(n) des elektronischen Bauteils variiert oder sehr gleichmäßig und homogen ist. Die endgültige Schichtdicke kann, natürlich in Abhängigkeit vom absoluten Dickenwert, in einem oder mehreren aufeinander folgenden Druckschritten erreicht werden. Auf diese Weise lassen sich hochwirksame elektrisch leitfähige Schichten mit Eigenschaften erzielen, die speziell an die Bedürfnisse und Anforderungen der Nutzer angepasst werden können.

Bei dem Verfahren der vorliegenden Erfindung werden vorzugsweise SIPs verwendet. Im Allgemeinen kann jedoch jedes elektronische Bauteil oder jede 3D-Elektronikbaugruppe, die zumindest teilweise von einer elektrisch leitfähigen Schicht bedeckt sein muss, für das Verfahren der vorliegenden Erfindung verwendet werden, wie beispielsweise ein AIP. Die Form der 3D-Elektronikbaugruppe kann prinzipiell beliebig sein. Vorzugsweise sollte die Form eine ebene Oberseite und ebene Seitenflächen aufweisen.

Als Druckobjekt werden generell bevorzugt quaderförmige oder würfelförmige Druckobjekte verwendet, bei denen die Seitenflächen unter einem 90°-Winkel zur Oberseite angeordnet ist. Denkbar ist aber auch, dass geometrisch andersartige Druckobjekte mit dem erfindungsgemäßen Tintenstrahldruckverfahren bedruckt werden, so zum Beispiel dreidimensionale Objekte in der Form eines Zylinders, eines Prismas, eines Kegelstumpfes oder auch eines Pyramidenstumpfes.

Die vorliegende Erfindung kann prinzipiell in jedem digitalen Inkjet-Druckverfahren eingesetzt werden, mit dem leitfähige und nichtleitfähige Schichten (Layer, Druckmuster) mit selektiv einstellbarer Dicke, hoher Strukturgleichmäßigkeit und Homogenität und hohem Durchsatz aufgebracht werden können.

Tintenstrahldrucker sind allgemein bekannt und können unterschiedliche, speziell auf die Bedürfnisse des Anwenders abgestimmte Konfigurationen aufweisen. Das Verfahren der vorliegenden Erfindung wird mit einem Tintenstrahldrucker mit einem oder auch mehreren Druckköpfen durchgeführt. Jeder Druckkopf weist eine Vielzahl von Druckdüsen auf, die in einer Druckdüsenebene und in einer Vielzahl von Reihen angeordnet sind. Die Erfindung ist nicht beschränkt auf einen Druckkopf mit zwei Druckdüsenreihen, sondern kann darüber hinaus auch mehrere Druckdüsenreihen aufweisen. Jede Druckdüsenreihe umfasst vorzugsweise eine Vielzahl von Druckdüsen. Die Druckbreite eines im Verfahren der vorliegenden Erfindung verwendeten Druckkopfes kann in Abhängigkeit von der Größe des Druckobjekts, wie z.B. einer 3D-Elektronikbaugruppe, gewählt werden, beispielsweise 30,5 cm (12 Zoll) und größer.

Bei dem erfindungsgemäßen Tintenstrahldruckverfahren wird zur Korrektur der Druckdaten für die Druckdüsen ein Vergleichsdruckbild herangezogen, das ohne die erfindungsgemäße Korrektur zuvor erzeugt wurde. Wichtig dabei ist, dass das Vergleichsdruckbild den gleichen Versatz (Abstand) zwischen zwei benachbarten Druckzeilen, die von Druckdüsen unterschiedlicher Druckdüsenreihen erzeugt wurden, aufweist, als wenn die Seitenfläche und die Oberseite, oder lediglich auch nur Abschnitte derselben, des Druckobjekts in einem kontinuierlichen Druckvorgang ohne die erfindungsgemäße Korrektur der Druckdaten bedruckt werden. Dieser Versatz benachbarter Druckzeilen im Vergleichsdruckbild, der ohne die erfindungsgemäße Korrektur der Druckdaten zustande kommt, wird sich meist auf der Seitenfläche des Druckobjekts zeigen. Denkbar ist aber auch, den Druckkopf so auszurichten, dass beim Vergleichsdruck die Seitenfläche des Druckobjekts als Referenzebene dient und sich folglich der Versatz der Druckzeilen auf der Oberseite des Druckobjekts zeigt.

Gemäß einer bevorzugten Ausführungsform kann das Vergleichsdruckbild durch Simulation unter Verwendung eines geometrisch identischen Objekts oder durch Bedrucken zumindest eines Abschnitts der Oberseite oder zumindest eines Abschnitts der Seitenfläche eines identischen Objekts erzeugt werden. Mit Hilfe einer Computersimulation können Vergleichsdruckbilder erhalten bzw. simuliert werden, die etwaige Höhenunterschiede und somit unterschiedliche Flugzeiten der Tintentropfen berücksichtigen. Um allerdings den Einfluss der Schwerkraft auf die Tintentropfen sowie etwaige gegenseitig wirkende fluiddynamische Effekte der Tintentropfen untereinander, wie zum Beispiel Oberflächenspannungen der Tintentropfen, zu berücksichtigen, ist es von Vorteil, wenn experimentell zuvor ein Vergleichsdruckbild durch Bedrucken der Seitenfläche und der Oberseite, oder zumindest von Abschnitten derselben, in einem kontinuierlichen Druckvorgang ohne Korrektur erhalten wird. Anhand dieses real existierenden Vergleichsdruckbildes kann dann ein etwaiger Versatz zweier benachbarter Druckzeilen experimentell bestimmt, wie zum Beispiel gemessen werden.

Gemäß einer bevorzugten Ausführungsform ist der erste Korrekturfaktor und/oder der zweite Korrekturfaktor abhängig vom Abstand d der beiden Druckzeilen auf der Seitenfläche des Objekts in dem zuvor erzeugten Vergleichsdruckbild. Beim Vergleichsdruckbild wird also die Oberseite des Druckobjekts als Referenzebene für den Druckkopf verwendet, so dass der Versatz benachbarter Druckzeilen auf der Seitenfläche in Erscheinung tritt.

Gemäß einer bevorzugten Ausführungsform variiert der erste Korrekturfaktor innerhalb der ersten Druckdüsenreihe und/oder der zweite Korrekturfaktor innerhalb der zweiten Druckdüsenreihe. Indem die Korrekturfaktoren für die Druckdüsen innerhalb einer Druckdüsenreihe variieren können, können auch geometrisch komplexere dreidimensionale Druckobjekte mit scharf definierter Druckkante auf der Seitenfläche (oder der Oberseite) bedruckt werden, da etwaige Höhenunterschiede oder Flugzeitenunterschiede selbst innerhalb einer Druckzeile kompensiert werden können.

Gemäß einer bevorzugten Ausführungsform wird der erste Korrekturfaktor und/oder der zweite Korrekturfaktor basierend auf einem Wert k bestimmt, wobei der Wert k sich aus der Gleichung ergibt:

$$k = \tan\alpha \times d.$$

Der Wert $\alpha$ ist hierbei der Neigungswinkel des Druckkopfes relativ zur planaren Ebene, auf dem das Druckobjekt angeordnet ist, und der Wert d entspricht dem Zeilenabstand der Druckzeilen auf der Seitenfläche oder der Oberseite eines identischen Druckobjekts in dem Vergleichsdruckbild.

Gemäß einer weiteren bevorzugten Ausführungsform umfasst das Tintenstrahldruckverfahren des Weiteren die Schritte des Erzeugens dreidimensionaler geometrischer Oberflächendaten der Oberseite und der Seitenfläche des dreidimensionalen Objekts und des Erzeugens zweidimensionaler geometrischer Oberflächendaten der Oberseite und der Seitenfläche des dreidimensionalen Objekts auf der Grundlage der dreidimensionalen geometrischen Oberflächendaten der Oberseite und der Seitenfläche des dreidimensionalen Objekts. Bei dieser Ausführungsform werden zunächst geometrische 3D-Oberflächendaten der 3D-Geometrie des Druckobjekts ermittelt oder definiert. Diese geometrischen 3D-Oberflächendaten können in 3D-Vektorgrafikdaten (Polygondaten) umgewandelt werden, die die Grundlage für eine digitale 3D-Objektdatei bilden. Die Umwandlung der geometrischen 3D-Oberflächendaten in geometrische 2D-Oberflächendaten erfolgt beispielsweise und bevorzugt durch Entfaltung (Unwrapping). Zu diesem Zweck können die freiliegenden Oberflächen durch ein Oberflächennetz definiert werden. Das Oberflächennetz wird so platziert, dass es sich durch bestimmte Punkte auf den Oberflächen des Druckobjekts erstreckt. Diese Punkte definieren vorzugsweise bis zu einem gewissen Grad die 3D-Form des Druckobjekts. Im Falle eines Quaders wären diese formgebenden Punkte zum Beispiel die Kanten des Quaders oder die acht Eckpunkte des Quaders.

Gemäß einer bevorzugten Ausführungsform werden die zweidimensionalen geometrischen Oberflächendaten der Seitenfläche des dreidimensionalen Druckobjekts durch Projektion der Seitenfläche des dreidimensionalen Druckobjekts in eine Referenzebene erzeugt, wobei die Referenzebene die Ebene der Oberseite des dreidimensionalen Druckobjekts umfasst. Gemäß dieser Ausführungsform wird also die Seitenfläche in die Ebene der Oberseite des Druckobjekts projiziert. Somit gibt es sowohl für die zweidimensionalen geometrischen Oberflächendaten der Oberseite als auch für die zweidimensionalen geometrischen Oberflächendaten der Seitenfläche des Druckobjekts die gleiche Referenz- bzw. Bezugsebene. Auf diese Weise können auch komplexere dreidimensionale Formen mit Seitenflächen, die nicht wie bei einem Quader in einem 90° Winkel zur Oberseite stehen, berücksichtigt werden, da die Projektion der Seitenfläche in die die Oberseite umfassende Referenzebene unabhängig von der Geometrie der Seitenfläche ist.

Da die Druckdüsenebene des Druckkopfes nicht parallel zur planaren Ebene steht, auf dem das Druckobjekt angeordnet ist, enthalten die (ungefalteten) 2D-Daten der geometrischen Oberfläche von Natur aus Verzerrungen aufgrund der Tatsache, dass die planare Ebene nicht parallel zur Druckdüsenebene verläuft. Da die Abstände eines 3D-Quaders in einer perspektivischen Ansicht auf einer 2D-Ebene umso kürzer erscheinen, je weiter sie in der realen Welt entfernt sind, spiegeln die (ungefalteten) geometrischen 2D-Oberflächendaten nicht unbedingt die realen Abstände wider. Solche Verzerrungen können vorzugsweise sodann korrigiert werden, indem die geometrischen 2D-Oberflächendaten in die Druckdüsenebene projiziert werden (Ebenenprojektion), wodurch man 2D-Druckdüsenebenendaten des Druckobjekts erhält. Zu diesem Zweck kann die Druckdüsenebene virtuell generiert werden, z. B. mit Hilfe einer Software, und die Korrektur erfolgt mathematisch unter Verwendung von Matrixalgebra, einschließlich einer Neuskalierung durch Komprimierung (mit einem bestimmten Faktor) und anschließender Scherung der geometrischen 2D-Oberflächendaten. Diesbezüglich wird auf die Europäische Patentanmeldung mit der Anmeldenummer EP 20 180 763 verwiesen, die am 18. Juni 2020 angemeldet wurde und die durch Bezugnahme hierin vollumfänglich enthalten ist.

Gemäß einer bevorzugten Ausführungsform werden die dreidimensionalen geometrischen Oberflächendaten der Oberseite und der Seitenfläche des dreidimensionalen Druckobjekts unter Verwendung von 3D-CAD-Daten oder von durch einen optischen Scanner erhaltene 3D-Daten erzeugt. Sowohl die Verwendung von 3D-CAD-Daten als auch solchen 3D-Daten, die durch optisches Scannen des Druckobjekts erhalten werden, können auf einfache Weise die für die Erzeugung der digitalen Druckdatei vorzugsweise verwendeten dreidimensionalen geometrischen Oberflächendaten des Druckobjekts erhalten werden. So steht beispielsweise eine Vielzahl von 3D-CAD-Daten in entsprechenden Bibliotheken zur Verfügung. Vor jedem Druckvorgang kann aber auch das Druckobjekt optisch gescannt werden, um so Daten über seine exakte dreidimensionale Form zu erhalten.

Gemäß einer Ausführungsform der Erfindung variieren die Abschusszeiten der aus der Vielzahl der Druckdüsen ausgegebenen Tintentropfen untereinander. Auf diese Weise können etwaige Höhenunterschiede der Druckdüsen zu den zu bedruckenden Abschnitten auf der Oberseite und der Seitenfläche des Druckobjekts und dadurch bedingte Flugzeitunterschiede ausgeglichen werden.

Gemäß einer Ausführungsform liegt der Winkel $\alpha$ zwischen der Druckdüsenebene und der planaren Ebene in einem Bereich von 20 bis 70°, vorzugsweise in einem Bereich von 20 bis 50°, und noch bevorzugter ist der Winkel $\alpha$ gleich 22,5°.

Gemäß einer bevorzugten Ausführungsform ist die Relativbewegung zwischen dem Druckobjekt und dem Druckkopf eine lineare geradlinige Bewegung. Durch die lineare geradlinige Bewegung parallel zur planaren Ebene kann eine optimierte Ausrichtung des Druckkopfes bzw. der Druckdüsen auf die Oberseite des Druckobjekts erfolgen, wodurch nur eine Kompensation der Flugzeitenunterschiede (Höhenunterschiede) zur Seitenfläche des Druckobjekts zur Erzeugung einer scharf definierten Druckkante erfolgen muss.

Gemäß einer bevorzugten Ausführungsform wird während der Relativbewegung zwischen dem Druckobjekt und dem Druckkopf das Druckobjekt relativ zu dem Druckkopf bewegt. Gemäß dieser Ausführungsform wird lediglich das Druckobjekt bewegt, während der Druckkopf stationär bleibt. Hierdurch wird der Aufbau des Tintenstrahldruckers, bei dem das hier beschriebene Tintenstrahldruckverfahren zur Anwendung kommt, wesentlich vereinfacht.

Gemäß einer bevorzugten Ausführungsform eilt während der Bewegung des Druckobjekts relativ zu dem Druckkopf eine Seitenkante, die zwei benachbarte Seitenflächen des Druckobjekts verbindet, voraus. Die vorauseilende Seitenkante ist vergleichbar mit dem Bug eines Schiffes, das die Rumpfflächen des Schiffes verbindet. Auf gleiche Weise sieht der Druckkopf zwei benachbarte Seitenflächen gleichzeitig und muss nicht nach dem Bedrucken einer Seitenfläche und der Oberseite um einen bestimmten Winkel gedreht werden, so dass im Anschluss eine weitere Seitenfläche des Druckobjekts bedruckt werden kann. Hierdurch können zwei Seitenflächen und die Oberseite des Druckobjekts in einem kontinuierlichen Druckprozess bedruckt werden.

Ein zweiter Aspekt der vorliegenden Erfindung betrifft ein Computerprogramm, das Instruktionen aufweist, die ein Steuergerät eines Tintenstrahldruckers veranlassen, die folgenden Schritte auszuführen, um zumindest einen Abschnitt einer Oberseite und zumindest einen Abschnitt einer Seitenfläche eines dreidimensionalen Objekts kontinuierlich mit Tinte zu bedrucken. Diese Schritte sind das Erzeugen von Druckdaten für jede Druckdüse einer Vielzahl von Druckdüsen eines Druckkopfes des Tintenstrahldruckers sowohl für den zu bedruckenden Abschnitt der Oberseite als auch für den zu bedruckenden Abschnitt der Seitenfläche des Objekts, wobei die Vielzahl von Druckdüsen sich in einer zweidimensionalen Druckkopfebene erstrecken, und wobei ein erster Teil der Vielzahl von Druckdüsen in einer ersten Druckdüsenreihe und ein zweiter Teil der Vielzahl von Druckdüsen in einer zweiten Druckdüsenreihe angeordnet sind, und wobei die erste Druckdüsenreihe von der zweiten Druckdüsenreihe in der Druckdüsenebene beabstandet ist. Überdies wird der Schritt des Korrigierens der Druckdaten für die Druckdüsen der ersten Druckdüsenreihe mit einem ersten Korrekturfaktor und/oder das Korrigieren der Druckdaten für die Druckdüsen der zweiten Druckdüsenreihe mit einem zweiten Korrekturfaktor veranlasst, und zwar derart, dass der erste Korrekturfaktor und/oder der zweite Korrekturfaktor anhand eines zuvor erzeugten Vergleichsdruckbildes, das zuvor ohne Korrektur erzeugt wurde, bestimmt wird, und dass der erste Korrekturfaktor und/oder der zweite Korrekturfaktor abhängig ist vom Abstand d der Druckzeile, die von den Druckdüsen der ersten Druckdüsenreihe erzeugt wurde, zu der Druckzeile, die von den Druckdüsen der zweiten Druckdüsenreihe erzeugt wurde, in dem zuvor erzeugten Vergleichsdruckbild.

Ein dritter Aspekt der vorliegenden Erfindung betrifft ein computer-lesbares Speichermedium, welches das zuvor beschriebene Computerprogramm darauf gespeichert hat.

Es wird darauf hingewiesen, dass die obigen Ausführungsformen untereinander in beliebiger Reihenfolge und unabhängig vom betreffenden Aspekt miteinander kombiniert werden können.

Diese und andere Aspekte der vorliegenden Erfindung werden anhand der im Folgenden beschriebenen bevorzugten Ausführungsformen der Erfindung unter Bezugnahme auf die Zeichnungen erläutert.

## KURZE BESCHREIBUNG DER ZEICHNUNGEN

Fig. 1 ist eine schematische Darstellung eines parallel zu einem zweidimensionalen Druckobjekt angeordneten Druckkopfes gemäß Stand der Technik;

Fig. 2 ist eine schematische Darstellung eines unter einem Winkel zu einem zweidimensionalen Druckobjekt geneigten Druckkopfes gemäß Stand der Technik;

Fig. 3 ist eine schematische Darstellung eines Druckkopfes, der unter einem Winkel zu einem dreidimensionalen Druckobjekt geneigt ist und dessen Oberseite bedruckt, gemäß Stand der Technik;

Fig. 4 ist eine schematische Darstellung eines Druckkopfes, der unter einem Winkel zu einem dreidimensionalen Druckobjekt geneigt ist und dessen Seitenfläche bedruckt, gemäß Stand der Technik;

Fig. 5 zeigt den Unterschied des Druckbildes einerseits auf der Oberfläche (links) und andererseits auf der Seitenfläche (rechts) des Druckobjekts gemäß Stand der Technik;

Fig. 6 ist eine schematische Darstellung, welche die Bewegung eines Druckkopfes mit zwei Druckdüsenreihen über ein dreidimensionales Druckobjekt zeigt;

Fig. 7 zeigt die Projektion der Seitenfläche in die Ebene der Oberseite eines dreidimensionalen Druckobjekts;

Fig. 8 zeigt den Versatz der Druckzeilen, die durch zwei Druckdüsenreihen auf der Seitenfläche eines dreidimensionalen Druckobjekts gemäß Stand der Technik erzeugt werden;

Fig. 9 zeigt eine fälschlicherweise durchgeführte Korrektur der Druckdaten für die Druckdüsen der Druckdüsenreihe B gemäß einer bevorzugten Ausführungsform der Erfindung;

Fig. 10 zeigt eine korrekt ausgeführte Korrektur der Druckdaten für die Druckdüsen der Druckdüsenreihe B gemäß einer bevorzugten Ausführungsform der Erfindung;

Fig. 11 zeigt eine lediglich suboptimale Korrektur der Druckdaten für die Druckdüsen der Druckdüsenreihe B;

Fig. 12 zeigt eine weitere suboptimale Korrektur der Druckdaten für die Druckdüsen der Druckdüsenreihe B;

Fig. 13 zeigt die von den Druckdüsen der Druckdüsenreihe A und B einerseits auf der Oberseite (links) und andererseits auf der Seitenwand eines dreidimensionalen Druckobjekts erzeugten Druckzeilen mit Korrektur gemäß einer bevorzugten Ausführungsform der Erfindung; und

Fig. 14 zeigt einen Vergleich des auf der Seitenfläche ohne Korrektur (links gemäß Stand der Technik) und mit Korrektur (rechts gemäß einer bevorzugten Ausführungsform der Erfindung) erzeugten Druckbildes.

## DETAILLIERTE BESCHREIBUNG EINER BEVORZUGTER AUSFÜHRUNGSFORM

Der vorliegenden Erfindung liegt die Feststellung zugrunde, dass beim Bedrucken der unter einem Winkel, vorzugsweise 90°, zur Oberseite stehenden Seitenfläche und anschließend der Oberseite eines dreidimensionalen Druckobjekts ein Versatz des Druckbildes auf der Oberseite oder der Seitenwand, und zwar abhängig davon, ob der Druckkopf auf die Oberseite oder die Seitenwand ausgerichtet ist, am äußersten Druckrand entsteht. Unter einem zur Oberseite des dreidimensionalen Druckobjekts ausgerichteten Druckkopf wird verstanden, dass die Abschusszeiten der Tintentropfen aus den in Reihen angeordneten Druckdüsen, die allesamt in einer zweidimensionalen Druckdüsenebene angeordnet sind, so variiert werden können, dass ein etwaiger Versatz auf der Oberseite des Druckobjekts kompensiert werden kann. Ein Versatz käme nämlich auch auf der Oberseite zustande aufgrund des physikalischen Abstandes der Druckdüsenreihen in der Druckdüsenebene.

Da sich die Höhenunterschiede bei einem auf die Oberseite des Druckobjekts ausgerichteten Druckkopf beim Übergang vom Bedrucken der Seitenfläche zum Bedrucken der Oberseite umkehren (siehe Vergleich von Fig. 3 und Fig. 4), wird gemäß der Erfindung eine Korrektur der Druckdaten (sog. "Rowshift") für die Druckdüsen jeder Druckdüsenreihe vorgenommen. Der dabei zur Verwendung kommende Korrekturfaktor kann für jede Düse einer Druckdüsenreihe konstant sein, kann aber auch innerhalb einer Druckdüsenreihe variieren.

Fig. 6 zeigt auf schematische Weise die Bewegung eines Druckkopfes 10 über ein dreidimensionales Objekt (Druckobjekt) 100, und zwar zu verschiedenen Zeitpunkten t1, t2, t3. Der Druckkopf 10 umfasst eine Vielzahl von Druckdüsen 12, die in Reihen in einer zweidimensionalen Druckdüsenebene 14 angeordnet sind. Bei dem in Fig. 6 gezeigten Druckkopf 10 umfasst die Druckdüsenreihe A insgesamt acht Druckdüsen 12, die als Gruppe mit dem Bezugszeichen A1 bezeichnet sind. Die Druckdüsenreihe B umfasst in dem in Fig. 6 gezeigten Beispiel ebenfalls acht Druckdüsen 12, die als Gruppe mit dem Bezugszeichen B1 bezeichnet sind. Die Anzahl der Druckdüsen 12 pro Reihe A, B kann im Sinne der Erfindung variieren. Ebenso kann der Druckkopf 10 mehr als nur zwei Druckdüsenreihen A, B aufweisen.

Die Druckdüsenreihen A, B sind in der Druckdüsenebene 14 zueinander beabstandet. Der Hintergrund hierfür ist, dass die aus den Druckdüsen 12 ausgegebenen Tintentropfen sich bei der Ausgabe nicht gegenseitig fluiddynamisch beeinflussen dürfen, da ansonsten deren Flugbahn sich unvorhersehbar verändern würde. Aus diesem Grund werden die Druckdüsen A1 der Druckdüsenreihe A versetzt zu den Druckdüsen B1 der Druckdüsenreihe B angeordnet. Mit anderen Worten, die mit der Nummer "1" in Fig. 6 bezeichnete Druckdüse der Druckdüsenreihe B ist in Längsrichtung der Druckdüsenreihen A, B mittig zwischen den Druckdüsen 1 und 2 der Druckdüsenreihe A angeordnet. Gleiches gilt für die übrigen Druckdüsen A1 der Druckdüsenreihe A.

Wie in Fig. 6 zu erkennen ist, "sehen" nicht alle Druckdüsen 12 zu einem gegebenen Zeitpunkt t1, t2 oder t3 nur die Oberseite 110 oder nur die Seitenfläche 120 des Druckobjekts 100. Abhängig von ihrer Position innerhalb jeder Druckdüsenreihe A, B sowie deren Position während des Druckvorgangs (während des Druckvorgangs bewegt sich vorzugsweise das Druckobjekt 100 relativ zu dem Druckkopf 10) können einzelne Druckdüsen 12 bereits die Oberseite 110 bedrucken, während andere Druckdüsen 12 einer anderen Druckdüsenreihe A, B oder sogar Druckdüsen 12 innerhalb derselben Druckdüsenreihe A, B noch die Seitenwand 120 bedrucken, beispielsweise zum Zeitpunkt t2.

Die unten stehende Tabelle zeigt sehr eindrücklich, zu welchem Zeitpunkt t1, t2 und t3 welche der mit arabischen Zahlen gekennzeichneten Druckdüsen 12 der Druckdüsenreihe A und der Druckdüsenreihe B jeweils die Seitenwand 120 und die Oberseite 110 des Druckobjekts 100 "sehen".

| Zeitpunkt | Seitenwand | Oberseite |
|---|---|---|
| t1 | Reihe B (4/5) | - |
| t2 | Reihe A (3/4/6/7) Reihe B(2/3/6/7) | Reihe A (5) Reihe B (4/5) |
| t3 | - | alle |

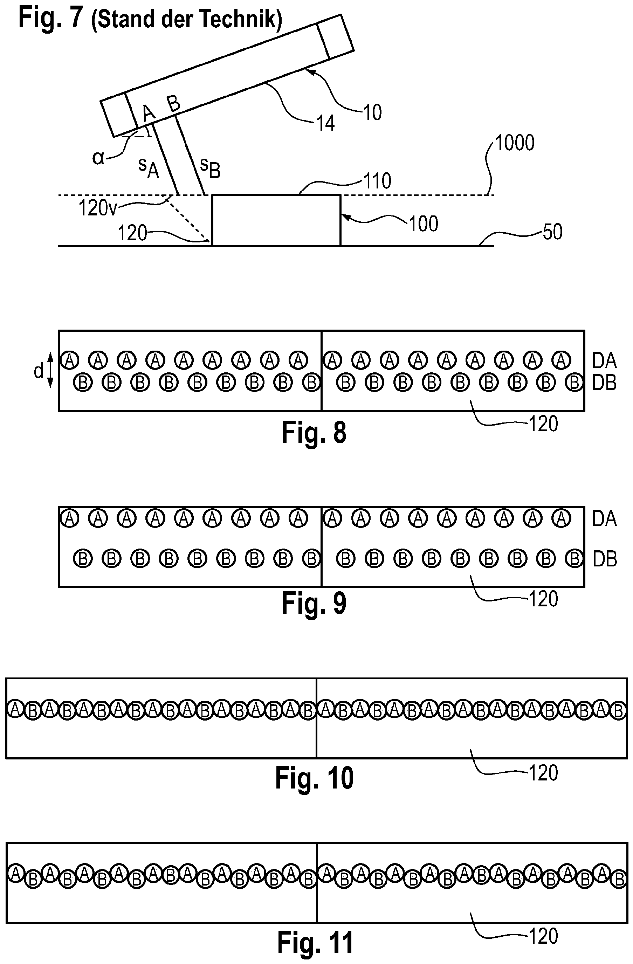

Es gibt somit eine zeitliche Asynchronität dahingehend, dass Druckdüsen 12 einer Druckdüsenreihe A oder B zu einem bestimmten Zeitpunkt die Oberseite 110 und andere Druckdüsen 12 derselben Druckdüsenreihe A oder B bereits die Seitenwand 120 "sehen". Um diese zeitliche Asynchronität auszugleichen, werden die Druckdaten für jede Druckdüse 12 dynamisch korrigiert. Dabei wird für jede Druckzeile DA, DB (Fig. 8) ermittelt, welcher Druckdüsenreihe A, B die betreffende Druckzeile DA, DB zugeordnet ist.

Unter Druckzeile DA, DB wird diejenige Zeile (Linie) im Druckbild auf der Seitenwand 120 (oder auf der Oberseite 110) des Druckobjekts 100 verstanden, die von der entsprechenden Druckdüsenreihe A oder B gedruckt wurde. Mit anderen Worten, die Druckdüsenreihe A druckt die Druckzeile DA, und die Druckdüsenreihe B druckt die Druckzeile DB.

Die Ausgabe eines Tintentropfens aus der jeweiligen Druckdüsenreihe A, B wird sodann derart manipuliert, dass die Abschusszeit des Tintentropfens basierend auf dem ermittelten Korrekturfaktor KA, KB verändert wird. Hierbei wird der Korrekturfaktor KA für die Korrektur der Druckdaten für die Druckdüsen A1 der Druckdüsenreihe A verwendet, und der Korrekturfaktor KB wird für die Korrektur der Druckdaten für die Druckdüsen B1 der Druckdüsenreihe B verwendet. Infolge der im Anschluss im Detail beschriebenen Korrektur der Druckdaten für die Druckdüsen A1, B1 der Druckdüsenreihen A, B wird eine scharfe, klar definierte Gerade (Druckkante) mit verringerter Waviness nicht nur auf der Oberseite 110, sondern auch auf der Seitenwand 120 des Druckobjekts 100 erhalten.

Es versteht sich, dass das Auftreffen der Tintentropfen auf der Seitenwand 120 von Druckdüse zu Druckdüse innerhalb einer Druckdüsenreihe A, B variieren kann. Durch die digitale Manipulation der Druckdaten, und zwar selektiv mit Hilfe eines konstanten oder auch variablen Korrekturfaktors, wird das dynamische Bedrucken der Oberseite 110 und mindestens einer Seitenwand 120 mit verringerter Waviness in einem kontinuierlichen Druckprozess ermöglicht. Ermöglicht wird dies auch unabhängig vom Neigungswinkel $\alpha$ des Druckkopfes 10 zur planaren Ebene 50, auf dem das Druckobjekt 100 angeordnet ist. Voraussetzung hierfür ist, dass die Oberseite 110 des Druckobjekts 100 parallel zur planaren Ebene 50 ist. Der Neigungswinkel $\alpha$ des Druckkopfes relativ zur planaren Ebene 50 verändert lediglich die Flugzeiten beziehungsweise die Abstände $S_A$ und $S_B$.

Wie in Fig. 7 gezeigt, wird vorzugsweise die Seitenwand 120 in die Ebene 1000 der Oberseite 110 projiziert (entfaltet), was eine virtuelle (projizierte) Seitenwand 120V ergibt.

In den Fign. 8-12 wird ein Beispiel dargelegt, wie der erfindungsgemäße Korrekturfaktor KA, KB vorzugsweise experimentell ermittelt werden kann.

In Fig. 8 sind die von den Druckdüsen A1, B1 der Druckdüsenreihen A, B auf der Seitenfläche 120 des Druckobjekts 100 erzeugten Druckzeilen DA, DB zu sehen. Zu erkennen ist, dass die Druckzeile (Drucklinie) DA zur Druckzeile (Drucklinie) DB auf der Seitenwand 120 um einen Abstand d beabstandet ist. Dieses Druckbild mit dem Versatz d wird als Vergleichsdruckbild bezeichnet, da es ohne Korrektur der Druckdaten für die Druckdüsen A1, B1 der Druckdüsenreihen A, B erzeugt wird.

Bei einem Beispiel, bei dem der Neigungswinkel 22,5° und die Druckauflösung 2400 dpi betrug und die Seitenwand 120 unter einem Winkel von 90° zur Oberseite 110 des dreidimensionalen Druckobjekts 100 angeordnet war sowie der Druckkopf 10 auf die Oberseite 110 des Druckobjekts 100 ausgerichtet war, betrug der Abstand d (Versatz) ungefähr 120 µm. Dieser wurde experimentell gemessen. Aufgrund etwaiger Meßungenauigkeiten (z.B. bedingt durch die Auflösung des verwendeten optischen Mikroskops) sowie physikalischer zu chemischer Verhältnisse von Tinte zur Oberfläche des Objekts ist der Meßwert von 120 µm mit einer Unschärfe von ca. 50 µm behaftet. Denkbar ist auch, diesen Versatz mittels einer Simulation zu ermitteln. Allerdings können nicht sämtliche fluiddynamischen Effekte, wie etwa die Oberflächenspannung der Tintentropfen, die gegenseitige Beeinflussung der Tintentropfen untereinander und eine daraus resultierende veränderte Flugbahn bis zur Seitenwand sowie die Wirkung der Schwerkraft auf die Tintentropfen bei einer Simulation berücksichtigt werden.

Um einen "Rowshift" bzw. eine Korrektur dieses Versatzes d zu erzielen, wird der virtuelle Versatz k verwendet, der sich aus der Projektion des gemessenen Versatzes d in die Ebene 1000 der Oberseite 110 des Druckobjekts 100 ergibt. Dies erfolgt aus der Gleichung:

$$k = \tan \alpha \times d.$$

Bei dem hier angegebenen Beispiel ($\alpha$ = 22,5°, d = 120 $\mu$m) beträgt der projizierte virtuelle Versatz (Abstand) k gleich 50 $\mu$m. Mit anderen Worten, ein projizierter virtueller Versatz von 50 $\mu$m ergibt auf der Seitenfläche 120 einen Versatz von 120 $\mu$m. Der zu dem Druckkopf 10 dazugehörige Encoder kann bei diesem Beispiel lediglich eine der beiden virtuellen Druckzeilen DA oder DB in Schritten von 10,5 $\mu$m verschieben, und zwar durch Korrektur der Druckdaten für die Düsen A1, B1 der Druckdüsenreihen A, B. Unter virtueller Druckzeile $DA_v$, $DB_v$ ist die Projektion der (realen) Druckzeile DA, DB in die Referenzebene 1000 gemeint.

Fig. 9 zeigt das Ergebnis, wenn die Druckzeile $DA_v$ der Druckdüsen A1 der Druckdüsenreihe A um ein Fünffaches der Encoderrasterung von 10,5 $\mu$m, das heißt um 52,5 $\mu$m nach oben (plus) verschoben wird. In diesem Fall wird der reale Versatz auf der Seitenfläche 120 noch größer und beträgt in diesem Fall ungefähr 250 $\mu$m. Daraus kann geschlossen werden, dass nicht die Druckzeile $DA_v$ der Druckdüsen A1 der Druckdüsenreihe A um 52,5 $\mu$m, und zwar ausgehend von dem in Fig. 8 gezeigten Druckbild, nach oben verschoben werden müssen, sondern vielmehr die Druckzeile $DB_v$ der Druckdüsen B1 der Druckdüsenreihe B um 52,5 $\mu$m nach oben verschoben (korrigiert) werden muss. Dieses Ergebnis ist in Fig. 10 gezeigt.

In Fig. 10 liegen die Druckzeilen DA und DB auf einer Linie, und der in Fig. 8 zu sehende Druckzeilenversatz um den Abstand d ist somit deutlich kompensiert bzw. ausgeglichen worden, wodurch die sogenannte Waviness signifikant verringert werden konnte. In Fig. 10 beträgt der Versatz (Abstand d) im Idealfall nahezu 0 $\mu$m. Jedoch ist aufgrund von Meßungenauigkeiten davon auszugehen, dass der reale Versatz etwa 50 $\mu$m beträgt.

In Fig. 11 ist das Ergebnis einer Gegenprüfung gezeigt. Hier wurde die Druckzeile $DB_v$ der Druckdüsen B1 der Druckdüsenreihe B um das Vierfache der Encoderrasterung von 10,5 $\mu$m, also um 42 $\mu$m nach oben (plus) verschoben. Es verbleibt daher ein Abstand zwischen den Druckzeilen DA und DB von ca. 18 $\mu$m. Die Waviness ist somit schlechter als in Fig. 10.

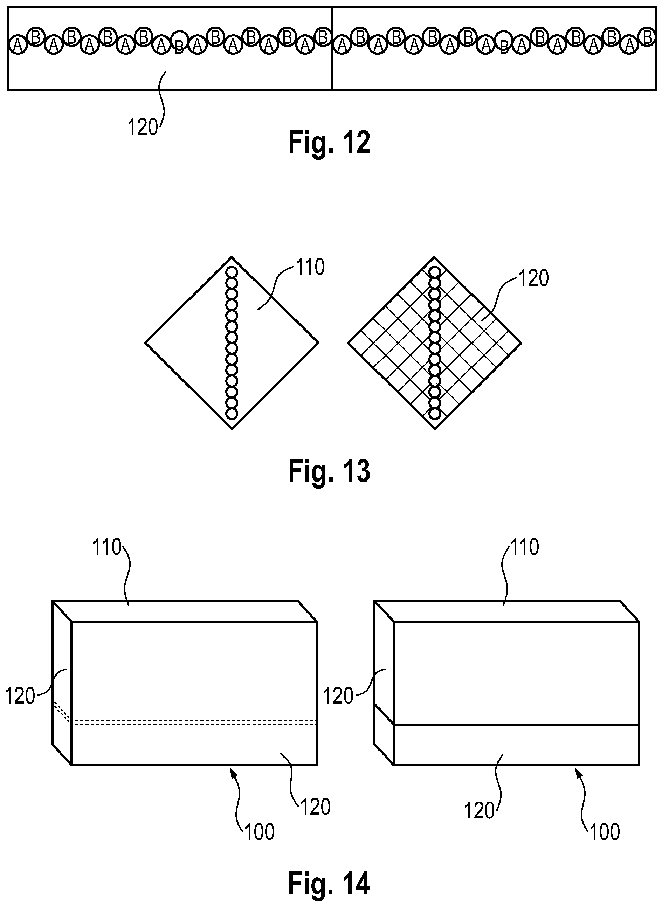

Eine weitere Gegenprüfung ist in Fig. 12 gezeigt. Hier wurde die Druckzeile $DB_v$ der Druckdüsen B1 der Druckdüsenreihe B um das Sechsfache der Encoderrasterung von 10,5 $\mu$m, also um 63 $\mu$m nach oben (plus) verschoben. Es verbleibt daher ein Abstand zwischen den Druckzeilen DA und DB von ca. 34 $\mu$m. Auch diese

Gegenprüfung zeigt ein schlechteres Ergebnis hinsichtlich der Waviness als das Ergebnis der Fig. 10.

Aus dieser Versuchsreihe ergibt sich somit, dass bei dem hier aufgeführten Beispiel (Neigungswinkel 22,5° und Encoderschritte von 10,5 $\mu$m) der beste Korrekturfaktor 52,5 $\mu$m beträgt. Bei einer Auflösung von 2400 dpi entspricht dies 5 Pixel.

Durch den "Rowshift" bzw. die Korrektur der Druckdaten wird, wie in Fig. 13 zu sehen ist, sowohl auf der Oberseite 110 als auch auf der Seitenwand 120 ein scharf definierter Druckrand ohne Versatz zwischen den Druckzeilen DA, DB erzeugt.

Unter Bezugnahme auf die Fig. 14 wird lediglich der Vollständigkeit halber nochmals das Ergebnis der erfindungsgemäßen Druckdatenkorrektur gezeigt, wonach ohne Korrektur das Druckbild auf den Seitenwänden 120 ungleichmäßig ist und es hierdurch zu einem ausgeprägten Versatz der einzelnen Druckzeilen (Waviness) kommt, während mit der Korrektur der Druckdaten eine klar definierte, scharf begrenzte Drucklinie auf den Seitenwänden 120, oder auf der Oberseite 110, erzeugt werden kann, und zwar abhängig davon, ob der Druckkopf 10 initial auf die Oberseite 110 oder die Seitenwand 120 ausgerichtet war.

Durch diese geringere Waviness des Druckrandes kann eine homogenere Schichtdicke über die gesamte Druckschicht erreicht werden.

Die Waviness (Welligkeit) kann mit einem geeigneten bildgebenden Verfahren gemessen werden, z.B. mit einem Mikroskop oder einem automatischen optischen Inspektionssystem (AOI). Beispielsweise kann eine durchschnittliche Welligkeit bestimmt werden, indem der Abstand zwischen den Spitzen und den Tälern der welligen Druckkante der Druckschicht relativ zu einer Referenzposition gemessen wird, vorzugsweise der Druckereinstellung, an der die Druckkante idealerweise liegen sollte, und indem die Messwerte einer Reihe von gedruckten Druckobjekten, z.B. einer Reihe von 400 Druckobjekten, gemittelt werden, wodurch ein Durchschnittswert für die Welligkeit der gedruckten Kante ermittelt werden kann. Alternativ kann auch ein Durchschnittswert für jede gedruckte Oberfläche (jede Seitenfläche separat) ermittelt werden.

An dieser Stelle sei angemerkt, dass vor der Korrektur der Druckdaten folgender Datenverarbeitungsprozess durchlaufen wird. Dieser Datenverarbeitungsprozess ist im Detail in der Europäischen Patentanmeldung mit der Anmeldenummer EP 20 180 763 beschrieben, die am 18. Juni 2020 angemeldet wurde und die durch Bezugnahme hierin vollumfänglich enthalten ist.

Zunächst werden geometrische 3D-Oberflächendaten der 3D-Geometrie des Druckobjekts ermittelt oder definiert. Diese 3D-Oberflächendaten können von einer externen Datenbank in Form von 3D-CAD-Daten zur Verfügung gestellt werden, oder sie können mit Hilfe eines Laserscanners gewonnen werden, der die Topographie der freiliegenden Oberflächen des 3D-Druckobjekts auf der planaren Ebene abtastet. Diese geometrischen 3D-Oberflächendaten können in 3D-Vektorgrafikdaten (Polygondaten) umgewandelt werden, die die Grundlage für eine digitale 3D-Objektdatei bilden.

In einem nächsten Schritt werden die geometrischen 3D-Oberflächendaten in geometrische 2D-Oberflächendaten umgewandelt, z.B. durch Entfaltung (Unwrapping). Das folgende, zugegebenermaßen vereinfachte Beispiel dient dazu, diesen Entfaltungsschritt auf anschauliche Weise zu erläutern.

Angenommen, das 3D-Objekt hat die Form eines Quaders und der Quader liegt mit seinem unteren Rechteck auf einer planaren Ebene, dann schneidet man den Quader entlang bestimmter Kanten auf, um den 3D-Quader zu entfalten, und legt den entfalteten Quader auf die planare Ebene. Der entfaltete 2D-Quader hat dann die Form eines symmetrischen Kreuzes mit fünf Rechtecken, einem zentralen Rechteck, das das obere Rechteck des 3D-Quaders darstellt, und vier Rechtecken neben den vier Seitenkanten des zentralen Rechtecks. Das untere Rechteck des 3D-Quaders ist aufgrund der Art des Entfaltungsprozesses und der Tatsache, dass darauf keine Schicht gedruckt werden soll, ohne Belang.

Um 2D-geometrische Oberflächendaten der freiliegenden 3D-Oberflächen des Druckobjekts zu erzeugen, können die freiliegenden Oberflächen durch ein Oberflächennetz definiert werden. Das Oberflächennetz wird so platziert, dass es sich durch bestimmte Punkte auf den Oberflächen des Druckobjekts erstreckt. Diese Punkte definieren vorzugsweise bis zu einem gewissen Grad die 3D-Form des Druckobjekts. Im Falle des oben erwähnten Quaders wären diese formgebenden Punkte zum Beispiel die Kanten des Quaders oder die acht Eckpunkte des Quaders.

Aufgrund der Neigung des Druckkopfes relativ zu dem Druckobjekt ist die Druckdüsenebene nicht parallel zur planaren Ebene, auf der das Druckobjekt angeordnet ist. Daher können die ungefalteten 2D-Daten der geometrischen Oberfläche von Natur aus Verzerrungen enthalten. Da die Abstände eines 3D-Quaders in einer perspektivischen Ansicht auf einer 2D-Ebene umso kürzer erscheinen, je weiter sie in der realen Welt entfernt sind, spiegeln die (ungefalteten) geometrischen 2D-Oberflächendaten nicht unbedingt die realen Abstände wider. Solche Verzerrungen können vorzugsweise sodann korrigiert werden, indem die geometrischen 2D-Oberflächendaten in die Druckdüsenebene projiziert werden (Ebenenprojektion), wodurch man 2D-Druckdüsenebenendaten des Druckobjekts erhält. Zu diesem Zweck kann die Druckdüsenebene virtuell generiert werden, z. B. mit Hilfe einer Software, und die Projektion in die Druckdüsenebene erfolgt mathematisch unter Verwendung von Matrixalgebra, einschließlich einer Neuskalierung durch Komprimierung (mit einem bestimmten Korrekturfaktor) und anschließender Scherung der geometrischen 2D-Oberflächendaten.

In einer weiteren beispielhaften Ausführungsform wird ein Computerprogramm oder Computerprogrammprodukt bereitgestellt, das dazu konfiguriert ist, ein Steuergerät eines Tintenstrahldruckers zu veranlassen, die oben beschriebenen Verfahrensschritte so auszuführen, dass zumindest einen Abschnitt einer Oberseite und zumindest ein Abschnitt einer Seitenfläche eines dreidimensionalen (3D) Druckobjekts kontinuierlich mit Tinte bedruckt wird.

Das Computerprogrammprodukt könnte daher auf einer Datenverarbeitungseinheit gespeichert sein, was ebenfalls Teil einer Ausführungsform sein könnte. Diese Datenverarbeitungseinheit kann dazu konfiguriert sein, die Schritte des oben beschriebenen Verfahrens durchzuführen oder deren Durchführung zu veranlassen. Das Computerprogramm kann in einen Arbeitsspeicher eines Datenprozessors geladen werden. Der Datenprozessor kann somit zur Durchführung des Verfahrens gemäß einer der vorhergehenden Ausführungsformen ausgestattet sein.

## Patentansprüche

1. Tintenstrahldruckverfahren zum kontinuierlichen Bedrucken zumindest eines Abschnittes einer Oberseite (110) und zumindest eines Abschnittes einer Seitenfläche (120) eines dreidimensionalen (3D) Objekts (100) mit Tinte, mit den Schritten:

   - Bereitstellen eines dreidimensionalen Objekts (100) auf einer planaren Ebene (50);
   - Bereitstellen eines Druckkopfes (10) mit einer Vielzahl von Druckdüsen (12) zum Ausgeben von Tinte in Form von Tropfen, wobei die Vielzahl von Druckdüsen (12) sich in einer zweidimensionalen Druckdüsenebene (14) erstrecken, und wobei ein erster Teil (A1) der Vielzahl von Druckdüsen (12) in einer ersten Druckdüsenreihe (A) und ein zweiter Teil (B1) der Vielzahl von Druckdüsen (12) in einer zweiten Druckdüsenreihe (B) angeordnet sind, und wobei die erste Druckdüsenreihe (A) von der zweiten Druckdüsenreihe (B) in der Druckdüsenebene (14) beabstandet ist, und wobei die Druckdüsenebene (14) unter einem Winkel $\alpha$ zur planaren Ebene (50) angeordnet ist;
   - Erzeugen von Druckdaten für jede Druckdüse der Vielzahl von Druckdüsen (12) sowohl für den zu bedruckenden Abschnitt der Oberseite (110) als auch für den zu bedruckenden Abschnitt der Seitenfläche (120) des Objekts (100);
   - Verursachen einer Relativbewegung zwischen dem Objekt (100) und dem Druckkopf (10);
   - zeilenförmiges Bedrucken des Abschnitts der Oberseite (110) und des Abschnitts der Seitenfläche (120) des Objekts (100) mit Tinte;
   - **dadurch gekennzeichnet, dass** vor dem Bedrucken des Abschnitts der Oberseite (110) und des Abschnitts der Seitenfläche (120) des Objekts (100) die Druckdaten für die Druckdüsen (A1) der ersten Druckdüsenreihe (A) mit einem ersten Korrekturfaktor (KA) und/oder die Druckdaten für die Druckdüsen (B1) der zweiten Druckdüsenreihe (B) mit einem zweiten Korrekturfaktor (KB) korrigiert werden, und dass der erste Korrekturfaktor (KA) und/oder der zweite Korrekturfaktor (KB) anhand eines zuvor erzeugten Vergleichsdruckbildes, das zuvor ohne Korrektur erzeugt wurde, bestimmt wird, und dass der erste Korrekturfaktor (KA) und/oder der zweite Korrekturfaktor (KB) abhängig ist vom Abstand d der Druckzeile (DA), die von den Druckdüsen (A1) der ersten Druckdüsenreihe (A) erzeugt wurde, zu der Druckzeile (DB), die von den Druckdüsen (B1) der zweiten Druckdüsenreihe (B) erzeugt wurde, in dem zuvor erzeugten Vergleichsdruckbild.

2. Tintenstrahldruckverfahren nach Anspruch 1, **dadurch gekennzeichnet, dass** das zuvor erzeugte Vergleichsdruckbild durch Simulation unter Verwendung eines geometrisch identischen Objekts (100') oder durch Bedrucken zumindest eines Abschnittes der Oberseite (110) oder zumindest eines Abschnittes der Seitenfläche (120) eines identischen Objekts (100) erzeugt wurde.

3. Tintenstrahldruckverfahren nach Anspruch 1 oder 2, **dadurch gekennzeichnet, dass** der erste Korrekturfaktor (KA) und/oder der zweite Korrekturfaktor (KB) abhängig ist vom Abstand d der Druckzeile (DA) zu der Druckzeile (DB) auf der Seitenfläche des Objekts (110) in dem zuvor erzeugten Vergleichsdruckbild.

4. Tintenstrahldruckverfahren nach einem der vorhergehenden Ansprüche, **dadurch gekennzeichnet, dass** der erste Korrekturfaktor (KA) innerhalb der ersten Druckdüsenreihe (A) und/oder der zweite Korrekturfaktor (KB) innerhalb der zweiten Druckdüsenreihe (B) variiert.

5. Tintenstrahldruckverfahren nach einem der vorhergehenden Ansprüche, **dadurch gekennzeichnet, dass** der erste Korrekturfaktor (KA) und/oder der zweite Korrekturfaktor (KB) basierend auf einem Wert k bestimmt wird, wobei der Wert k sich aus der Gleichung ergibt:

$$k = \tan \alpha \times \mathrm{d}.$$

6. Tintenstrahldruckverfahren nach einem der vorhergehenden Ansprüche, des Weiteren mit den Schritten:

- Erzeugen dreidimensionaler geometrischer Oberflächendaten der Oberseite (110) und der Seitenfläche (120) des dreidimensionalen Objekts (100), und
- Erzeugen zweidimensionaler geometrischer Oberflächendaten der Oberseite (110) und der Seitenfläche (120) des dreidimensionalen Objekts (100) auf der Grundlage der dreidimensionalen geometrischen Oberflächendaten der Oberseite (110) und der Seitenfläche (120) des dreidimensionalen Objekts (100).

7. Tintenstrahldruckverfahren nach Anspruch 6, **dadurch gekennzeichnet, dass** die zweidimensionalen geometrischen Oberflächendaten der Seitenfläche des dreidimensionalen Objekts (100) durch Projektion der Seitenfläche des dreidimensionalen Objekts (100) in eine Referenzebene (1000) erzeugt werden, und dass die Referenzebene (1000) die Ebene der Oberseite (120) des dreidimensionalen Objekts (100) umfasst.

8. Tintenstrahldruckverfahren nach einem der Ansprüch 6 oder 7, **dadurch gekennzeichnet, dass** die dreidimensionalen geometrischen Oberflächendaten der Oberseite (110) und der Seitenfläche (120) des dreidimensionalen Objekts (100) unter Verwendung von 3D-CAD Daten oder von durch einen optischen Scanner erhaltene 3D Daten erzeugt werden.

9. Tintenstrahldruckverfahren nach einem der vorhergehenden Ansprüche, **dadurch gekennzeichnet, dass** die Abschusszeiten der aus der Vielzahl der Druckdüsen (12) ausgegebenen Tintentropfen untereinander variieren.

10. Tintenstrahldruckverfahren nach einem der vorhergehenden Ansprüche, **dadurch gekennzeichnet, dass** der Winkel $\alpha$ zwischen der Druckdüsenebene (14) und der planaren Ebene (50) in einem Bereich von 20° bis 70° liegt, vorzugsweise in einem Bereich von 20° bis 50° liegt, und noch bevorzugter 22,5° beträgt.

11. Tintenstrahldruckverfahren nach einem der vorhergehenden Ansprüche, **dadurch gekennzeichnet, dass** die Relativbewegung zwischen dem dreidimensionalen Objekt (100) und dem Druckkopf (10) eine lineare geradlinige Bewegung ist.

12. Tintenstrahldruckverfahren nach einem der vorhergehenden Ansprüche, **dadurch gekennzeichnet, dass** während der Relativbewegung zwischen dem dreidimensionalen Objekt (100) und dem Druckkopf (10) das dreidimensionalen Objekt (100) relativ zu dem Druckkopf (10) bewegt wird.

13. Tintenstrahldruckverfahren nach Anspruch 12, **dadurch gekennzeichnet, dass** während der Bewegung des dreidimensionalen Objekts (100) relativ zu dem Druckkopf (10) eine Seitenkante, die zwei benachbarte Seitenflächen (120) des dreidimensionalen Objekts (100) verbindet, vorauseilt.

14. Ein Computerprogramm, das Instruktionen aufweist, die ein Steuergerät eines Tintenstrahldruckers veranlassen, die folgenden Schritte auszuführen, um zumindest einen Abschnitt einer Oberseite (110) und zumindest einen Abschnitt einer Seitenfläche (120) eines dreidimensionalen (3D) Objekts (100) kontinuierlich mit Tinte zu bedrucken:

- Erzeugen von Druckdaten für jede Druckdüse einer Vielzahl von Druckdüsen (12) eines Druckkopfes (10) des Tintenstrahldruckers sowohl für den zu bedruckenden Abschnitt der Oberseite (110) als auch für den zu bedruckenden Abschnitt der Seitenfläche (120) des Objekts (100), wobei die Vielzahl von Druckdüsen (12) sich in einer zweidimensionalen Druckkopfebene (14) erstrecken, und wobei ein erster Teil (A1) der Vielzahl von Druckdüsen (12) in einer ersten Druckdüsenreihe (A) und ein zweiter Teil (B1) der Vielzahl von Druckdüsen (12) in einer zweiten Druckdüsenreihe (B) angeordnet sind, und wobei die erste Druckdüsenreihe (A) von der zweiten Druckdüsenreihe (B) in der Druckdüsenebene (14) beabstandet ist; und

- Korrigieren der Druckdaten für die Druckdüsen (A1) der ersten Druckdüsenreihe (A) mit einem ersten Korrekturfaktor (KA) und/oder Korrigieren der Druckdaten für die Druckdüsen (B1) der zweiten Druckdüsenreihe (B) mit einem zweiten Korrekturfaktor (KB), derart, dass der erste Korrekturfaktor (KA) und/oder der zweite Korrekturfaktor (KB) anhand eines zuvor erzeugten Vergleichsdruckbildes, das zuvor ohne Korrektur erzeugt wurde, bestimmt wird, und dass der erste Korrekturfaktor (KA) und/oder der zweite Korrekturfaktor (KB) abhängig ist vom Abstand d der Druckzeile (DA), die von den Druckdüsen (A1) der ersten Druckdüsenreihe (A) erzeugt wurde, zu der Druckzeile (DB, die von den Druckdüsen (B1) der zweiten Druckdüsenreihe (B) erzeugt wurde, in dem zuvor erzeugten Vergleichsdruckbild.

15. Ein computer-lesbares Speichermedium, welches das Computerprogramm nach Anspruch 14 darauf gespeichert hat.

## Fig. 1 (Stand der Technik)

$s_A = s_B$

## Fig. 2 (Stand der Technik)

$s_A < s_B$

## Fig. 3 (Stand der Technik)

$s_A < s_B$

# Fig. 4 (Stand der Technik)

$s_A > s_B$

$\alpha$  $s_A$  $s_B$

10
14
110
1000
120
100
50

# Fig. 5 (Stand der Technik)

110

120

# Fig. 6

t1  t2  t3

A B  A B  A B

12
12
B1
14
A1
10

110

100

120

## Fig. 7 (Stand der Technik)

Fig. 8

Fig. 9

Fig. 10

Fig. 11

**Fig. 12**

**Fig. 13**

**Fig. 14**

Europäisches
Patentamt

European
Patent Office

Office européen
des brevets

# EUROPÄISCHER RECHERCHENBERICHT

Nummer der Anmeldung

EP 23 21 8949

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2023/202200 A1 (HALLER AMIT [US] ET AL) 29. Juni 2023 (2023-06-29) * Absätze [0011], [0037], [0086] - [0087], [0039] - [0046], [0101], [0118]; Abbildungen 1-14 * - - - - - | 1-15 | INV. B41J3/407 B41M5/00 |
| A | EP 3 925 786 A1 (HERAEUS DEUTSCHLAND GMBH & CO KG [DE]) 22. Dezember 2021 (2021-12-22) * Absätze [0024], [0041] - [0043]; Abbildung 3 * - - - - - | 1-15 | |
| A | US 2001/017085 A1 (KUBO NAOKI [JP] ET AL) 30. August 2001 (2001-08-30) * das ganze Dokument * - - - - - | 1-15 | |
| A | JP 2009 012430 A (INAX CORP) 22. Januar 2009 (2009-01-22) * das ganze Dokument * - - - - - | 1-15 | |
| A | WO 2014/163196 A1 (KONICA MINOLTA INC [JP]) 9. Oktober 2014 (2014-10-09) * das ganze Dokument * - - - - - | 1-15 | RECHERCHIERTE SACHGEBIETE (IPC) B41J B41M |

Der vorliegende Recherchenbericht wurde für alle Patentansprüche erstellt

| Recherchenort | Abschlußdatum der Recherche | Prüfer |
|---|---|---|
| Den Haag | 29. Mai 2024 | Cavia Del Olmo, D |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 21 8949

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-05-2024

| Im Recherchenbericht angeführtes Patentdokument | Datum der Veröffentlichung | Mitglied(er) der Patentfamilie | Datum der Veröffentlichung |
|---|---|---|---|
| US 2023202200 A1 | 29-06-2023 | US 2023202200 A1 | 29-06-2023 |
| | | WO 2021245659 A1 | 09-12-2021 |
| EP 3925786 A1 | 22-12-2021 | CN 113815319 A | 21-12-2021 |
| | | EP 3925786 A1 | 22-12-2021 |
| | | JP 7194777 B2 | 22-12-2022 |
| | | JP 2022000341 A | 04-01-2022 |
| | | KR 20210157331 A | 28-12-2021 |
| | | PL 3925786 T3 | 25-03-2024 |
| | | TW 202222599 A | 16-06-2022 |
| | | US 2021394455 A1 | 23-12-2021 |
| US 2001017085 A1 | 30-08-2001 | KEINE | |
| JP 2009012430 A | 22-01-2009 | KEINE | |
| WO 2014163196 A1 | 09-10-2014 | JP 6376123 B2 | 22-08-2018 |
| | | JP WO2014163196 A1 | 16-02-2017 |
| | | WO 2014163196 A1 | 09-10-2014 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20190270306 A1
- US 11234334 B2

- EP 20180763 A